# EUROPÄISCHE PATENTSCHRIFT

(11) **EP 0 818 888 B1**
(45) Veröffentlichungstag und Bekanntmachung des Hinweises auf die Patenterteilung: **27.09.2000**
(21) Anmeldenummer: 97201866.7
(22) Anmeldetag: 19.06.1997
(51) Int. Cl.: H03J 5/24

(54) **Umschaltbares Bandfilter für Mehrband-Tuner**
Switchable band filter for multiband-tuner
Filtre passe-bande commutable pour tuner multi-gammes

(30) Priorität: 12.07.1996 DE 19628186
(43) Veröffentlichungstag der Anmeldung: 14.01.1998
(73) Patentinhaber: Philips Corporate Intellectual Property GmbH, 52064 Aachen (DE); Koninklijke Philips Electronics N.V., 5621 BA Eindhoven (NL)
(72) Erfinder: Lange, Joachim, Röntgenstrasse 24, 22335 Hamburg (DE)
(74) Vertreter: von Laue, Hanns-Ulrich

(56) Entgegenhaltungen:
- EP-A- 0 429 914
- GB-A- 2 117 588
- GB-A- 2 196 198

## Beschreibung

Die Erfindung betrifft ein umschaltbares Bandfilter für einen Mehrband-Tuner mit wenigstens zwei parallel angeordneten einzelnen Bandfiltern, wobei in den einzelnen Bandfiltern jeweils wenigstens eine Kapazitätsdiode zur Frequenz-Abstimmung wenigstens eines Schwingkreises der einzelnen Bandfilter vorgesehen ist und wobei die einzelnen Bandfilter jeweils eingangs- und ausgangsseitig je eine Schaltdiode aufweisen, welche mittels Gleichspannungen in den sperrenden oder in den leitenden Zustand schaltbar ist.

Aus der deutschen Patentschrift 39 39 741 ist eine Tunerschaltung bekannt, in der zwei parallel angeordnete umschaltbare Bandfilter vorgesehen sind. Die Umschaltung wird dort mittels am Eingang und am Ausgang der Bandfilter vorgesehener Schaltdioden vorgenommen. Innerhalb der Bandfilter sind ferner Kapazitätsdioden zur Abstimmung der Bandfilter vorgesehen. Durch die Schaltdioden kann zwar die gegenseitige Entkopplung der Bandfilter verbessert werden, jedoch weist auch das gesperrte Bandfilter eine relativ niedrige Durchgangsdämpfung auf, so daß im Zusammenführungspunkt der beiden Bandfilter nicht nur das Signal des eingeschalteten sondern in nicht ausreichend gedämpftem Umfange auch das Signal des vermeintlich abgeschalteten Bandfilters erscheint. Somit wird derjenige Frequenzbereich, den das gesperrte Bandfilter verarbeitet, nicht genügend gedämpft.

Es ist Aufgabe der Erfindung, umschaltbare Bandfilter zu schaffen, die im gesperrten Zustand neben einer guten gegenseitigen Entkopplung auch eine gute Durchgangsdämpfung aufweisen.

Diese Aufgabe ist erfindungsgemäß dadurch gelöst, daß die Kapazitätsdioden zusätzlich zur Sperrung der einzelnen Bandfilter einsetzbar sind und so in den Schwingkreis des umschaltbaren Bandfilters integriert sind, daß die Kapazitätsdioden in Abhängigkeit eines Schalt-Potentials den Schwingkreis gegen ein Schalt-Potential koppeln und daß Mittel vorgesehen sind, welche bei Sperrung eines einzelnen Bandfilters der jeweiligen Kapazitätsiode ein Schaltpotential und welche bei Betrieb im nicht gesperrten Zustand der jeweiligen Kapazitätsdiode eine Abstimmspannung zuführen.

In dem erfindungsgemäßen umschaltbaren Bandfilter wird die Kapazitätsdiode in den einzelnen Bandfiltern sowohl dazu eingesetzt, die Frequenz der einzelnen Bandfilter abzustimmen. Hierzu wird eine variable Spannung angelegt, in Abhängigkeit derer die Kapazität der Kapazitätsdiode sich verändert und somit die Resonanzfrequenz des Schwingkreises des einzelnen Bandfilters verändert. Außerdem wird die Kapazitätsdiode zusätzlich dazu eingesetzt, die Sperrung des einzelnen Bandfilters im gesperrten Zustand zu verbessern, d.h. insbesondere die Durchgangsdämpfung zu erhöhen. Dazu ist die Kapazitätsdiode so verschaltet, daß sie nach Anlegen eines Schaltpotentials den Schwingkreis des einzelnen Bandfilters gegen ein Schaltpotential koppelt. Dadurch werden alle Signalanteile, die trotz der Schaltdioden in das einzelne Bandfilter gelangen, gegen das Schalt-Potential abgeführt. Diese Maßnahme verbessert die Durchgangsdämpfung des einzelnen Bandfilters im gesperrten Zustand beträchtlich; es können durch diese Maßnahme 50 bis 60 dB Durchgangsdämpfung erzielt werden.

Gemäß einer Ausgestaltung der Erfindung ist vorgesehen, daß zur Sperrung der einzelnen Bandfilter die jeweilige Kapazitätsdiode mittels des Schaltpotentials in den leitenden Zustand versetzt wird und den jeweiligen Schwingkreis gegen das Schaltpotential koppelt.

Dabei kann die Kapazitätsdiode insbesondere so verschaltet sein, daß sie durch Anlegen des Schaltpotentials in den leitenden Zustand versetzt wird und somit in dem Schwingkreis auftretende Spannungen bzw. Signale gegen das Schaltpotential koppelt. Die Kapazitätsdiode arbeitet in diesem Zustand niederohmig und kann bei nicht angelegtem Schaltpotential in dem Bereich betrieben werden, in dem ihre Kapazität in Abhängigkeit einer angelegten Abstimmspannung veränderbar ist.

Gemäß einer weiteren Ausgestaltung der Erfindung ist vorgesehen, daß die Kapazitätsdioden anodenseitig mit einer positiven Gleichspannung und kathodenseitig mit dem Schaltpotential und über wenigstens eine Kapazität mit dem Bezugspotential gekoppelt sind.

Befindet sich das einzelne Bandfilter nicht im gesperrten Zustand, wird die Kapazitätsdiode in dem Übergangsbereich in den leitenden Bereich betrieben. Durch Veränderung der Spannung verändert sich ihre Kapazität und sie kann zur Abstimmung des Schwingkreises des einzelnen Bandfilters eingesetzt werden. Wird das kathodenseitig eingekoppelte Schaltpotential aktiviert, so wird die Kapazitätsdiode vollständig leitend und führt in dem Schwingkreis existierende Wechselspannungen gegen das Bezugspotential ab.

Im nicht gesperrten Zustand des einzelnen Bandfilters bildet die Kapazitätsdiode einen Teil des Schwingkreises des einzelnen Bandfilters, wozu gemäß einer weiteren Ausgestaltung der Erfindung vorgesehen ist, daß die Kapazitätsdioden anodenseitig mit wenigstens einer Induktivität des jeweiligen Schwingkreises gekoppelt ist.

Im nicht gesperrten Zustand des einzelnen Bandfilters wird die Kapazitätsdiode zur Frequenzabstimmung des einzelnen Bandfilters eingesetzt. Dazu ist gemäß einer weiteren Ausgestaltung der Erfindung vorgesehen, daß bei inaktivem Schalt-Potential eine Abstimmspannung zur Frequenzabstimmung der einzelnen Bandfilter auf die Kathode der jeweiligen Kapazitätsdioden gekoppelt wird. In Abhängigkeit dieser Abstimmspannung verändert die Kapazitätsdiode ihre Kapazität.

Die obenbeschriebenen Vorteile des umschaltbaren Bandfilters treten insbesondere in Erscheinung bei Einsatz in Mehrbandtunern. In derartigen Tunern sind meist mehrere Bandfilter parallel angeordnet. Das erfindungsgemäße umschaltbare Bandfilter erreicht hier nicht nur eine gute gegenseitige Entkopplung der einzelnen Bandfilter sondern auch eine gute Durchgangsdämpfung des jeweils gesperrten einzelnen Bandfilters. Insbesondere ist für einen derartigen Mehrbandtuner gemäß einer weiteren Ausgestaltung der Erfindung vorgesehen, daß der Tuner einen Breitbandverstärker aufweist, dem ein umschaltbares Bandfilter nachgeschaltet ist.

Durch die niederohmige Auslegung des Breitbandverstärkers kann die Wirkung der Schaltdioden noch verstärkt werden, da sie besser in den gesperrten Zustand geführt werden können und damit eine bessere Entkopplung der einzelnen Bandfilter erzielt wird.

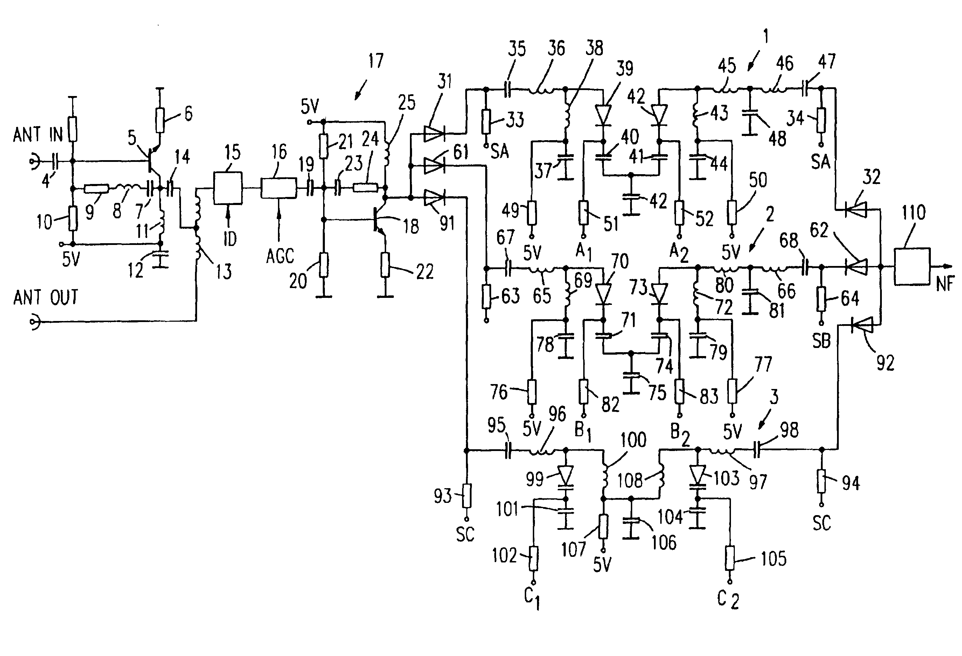

Nachfolgend wird ein Ausführungsbeispiel der Erfindung anhand der Zeichnung näher erläutert.

Die einzige Figur zeigt einen Mehrbantuner mit drei parallel angeordneten einzelnen Bandfiltern 1,2 und 3. Die drei einzelnen Bandfilter sind erfindungsgemäß aufgebaut und für unterschiedliche Frequenzbereiche ausgelegt. Es ist jeweils nur eines der drei einzelnen Bandfilter 1,2,3 aktiviert; die übrigen zwei einzelnen Bandfilter sind in den gesperrten Zustand geschaltet. In dem gesperrten Zustand sollen diese Bandfilter eine möglichst hoh untereinander existieren, damit diese sich gegenseitig möglichst wenig beeinflussen.

Dem in der Figur dargestellten Tuner wird eingangsseitig an seinem Antenneneingang ANT IN ein HF-Eingangssignal zugeführt, das über einen Koppelkondensator 4 an die Basis eines PMP-Transistors 5 gelangt, dessen Emitter über einen Widerstand 6 mit Bezugspotential gekoppelt ist. Diese Eingangsstufe weist ein Filter auf, das auf der Reihenschaltung einer Kapazität 7, einer Induktivität 8 und einem Widerstand 9 aufgebaut ist, die zwischen Kollektor des Transistors 5 und dem Verbindungspunkt der Kapazität 4 und der Basis des Transistors 5 geschaltet ist. Dieser Verbindungspunkt ist ferner über einen Widerstand 10 mit Versorgungspotential (5 V) gekoppelt. Der Kollektor ist ferner über eine Reihenschaltung einer Induktivität 11 und einer Kapazität 12 mit Bezugspotential gekoppelt.

Bestandteil dieser Eingangsschaltung mit dem Transistor 5 ist ein sogenannter Powersplitter, der mittels einer Induktivität 13 aufgebaut ist, die einen Mittelabgriff 14 aufweist. Der Kollektor des Transistors 5 ist über eine Kapazität 14 mit diesem Mittelabgriff der Induktivität 13 gekoppelt. Ein erster Endabgriff der Induktivität 13 bildet einen Ausgang, der in der Figur mit ANT OUT gekennzeichnet ist und an dem das Antennensignal als Ausgangssignal zur Verfügung gestellt wird. Eine derartige Schaltung ist beispielsweise für Videorekorder erforderlich, bei denen das Antenneneingangssignal zusätzlich als Ausgangssignal für einen Fernseher zur Verfügung gestellt werden soll.

Ein zweiter Endabgriff der Induktivität 13 wird einem Vorkreis 15 zugeführt, welcher bereits eine sehr breite Vorselektion vornimmt.

Diesem Vorkreis 15 ist ein Verstärker oder Dämpfungselement 16 mit einstellbarer Verstärkung oder Dämpfung nachgeschaltet. Diesem Verstärker oder Dämpfungselement 16 ist ein Signal AGC für automatic Gain Control zugeführt, welches in Abhängigkeit in der Figur nicht dargestellter Schaltungselemente des Tuners den Verstärker oder Dämpfungselement 16 so steuert, daß in dem Tuner eine gewünschte Verstärkung erzielt wird.

Dem Verstärker oder Dämpfungselement 16 ist ein Breitbandverstärker 17 nachgeschaltet, welcher einen Verstärkungstransistor 18 aufweist. Dieser ist basisseitig über einen Koppelkondensator 19 mit dem Ausgang des Verstäkers oder Dämpfungsselements 16 verbunden. Die Basis ist ferner über einen Widerstand 20 mit Bezugspotential und über einen Widerstand 21 mit Versorgungspotential + 5 V gekoppelt. Der Emitter des Transistors 18 ist über einen Widerstand 22 mit Bezugspotential verbunden. Kollektor und Basis des Transistors 18 sind über eine Kapazität 23 und einen Widerstand 24 gekoppelt. Der Kollektor ist ferner über eine Induktivität 25 mit Versorgungspotential gekoppelt.

Der Breitwandverstärker 17 mit dem Transistor 18 weist eine niedrigere Eingangsund Ausgangsimpedanz von vorzugsweise weniger als 100 Ohm auf. Damit kann die Arbeitsweise der nachfolgenden Bandfilter verbessert werden. Insbesondere können diese im gesperrten Zustand besser entkoppelt werden.

Dem Breitbandverstärker 17 sind in paralleler Anordnung die drei umschaltbaren und abstimmbaren Bandfilter 1, 2 und 3 nachgeschaltet.

Das erste einzelne Bandfilter 1 weist eingangsseitig eine Schaltdiode 31 und ausgangsseitig eine Schaltdiode 32 auf. Hinter der eingangsseitig vorgesehenen Schaltdiode 31 kann über einen Widerstand 33 eine Schaltspannung SA eingekoppelt werden. In entsprechender Weise geschieht dies ausgangsseitig über einen Widerstand 34. Mittels des Schaltsignals SA können die eingangs- bzw. ausgangsseitig vorgesehenen Schaltdioden 31 bzw. 32 in den gesperrten Zustand versetzt werden, so daß eine relativ gute Entkopplung der Filter gegeneinander erzielt wird. Die Schaltdioden 31 bzw. 32 bewirken jedoch noch nicht eine sehr gute Durchgangsdämpfung des Bandfilters.

Das in der Figur dargestellte einzelne Bandfilter 1 weist eingangsseitig eine Koppelkapazität 35 und eine nachgeschaltete Koppelinduktivität 36 auf. Der abstimmbare Schwingkreis des einzelnen Bandfilters 1 ist aus einer über eine Kapazität 37 auf's Bezugspotential gekoppelte Induktivität 38 sowie eine mit dieser anodenseitig gekoppelte Kapazitätsdiode 39 und einer mit dieser kathodenseitig verbundenen Kapazität 40 aufgebaut. Der Verbindungspunkt zwischen der Induktivität 38 und der Kapazitätsdiode 39 ist mit der Koppelinduktivität 36 verbunden.

Das einzelne Bandfilter 1 weist ferner einen zweiten Schwingkreis auf, der in entsprechender Weise aufgebaut ist. Es ist eine Kapazität 41 vorgesehen, welche mit der Kapazität 40 verbunden ist. Die Kapazität 41 ist mit der Kathode einer zweiten Kapazitätsdiode 42 gekoppelt, welche anodenseitig mit einer Schwingkreisinduktivität 43 verbunden ist, welche über eine Kapazität 44 mit Bezugspotential gekoppelt ist.

Der Verbindungspunkt der Kapazitäten 40 und 41 ist über eine Kapazität 42 mit Bezugspotential gekoppelt. Das einzelne Bandfilter 1 weist ausgangsseitig ein Tiefpaßfilter auf, dessen Induktivität 45 auf den Verbindungspunkt der Anode der Kapazitätsdiode 42 und der Schwingkreisinduktivität 43 gekoppelt ist. Ausgangsseitig ist die Induktivität 45 über eine Kapazität 48 mit Bezugspotential gekoppelt. Es ist ein Tiefpaßfilter mit einer Induktivität 46 und einer Kapazität 47 nachgeschaltet. Hinter der Koppelkapazität 47 ist die Schaltdiode 32 vorgesehen.

Auf beide Schwingkreise ist über Widerstände 49 bzw. 50 eine positive Versorgungsspannung (5 V) auf die Verbindungspunkte zwischen den Induktivitäten 38 und der Kapazität 37 bzw. zwischen der Induktivität 43 und der Kapazität 44 eingekoppelt.

Es sind ferner Abstimmspannungen A₁, A₂ über Widerstände 51 und 52 auf die Verbindungspunkte zwischen der Kathode der Kapazitätsdiode 39 und der Kapazität 40 und auf den Verbindungspunkt der Kathode der Kapazitätsdiode 42 und der Kapazität 41 eingekoppelt.

Für den Betrieb im nicht gesperrten Zustand sind die Schaltsignale SA deaktiviert. Ferner werden Abstimmspannungen A₁ und A₂ zugeführt, welche die Kapazitätsdioden 39 bzw. 42 so in ihrem gesperrten Zustand betreiben, daß sich ihre Kapazität verändert. Damit wird die Resonanzfrequenz der Schwingkreise verändert und es kann eine Abstimmung der Bandfilter erfolgen.

Für die Sperrung des einzelnen Bandfilters 1 werden die Schaltsignale SA aktiviert. Dies führt dazu, daß die Dioden 31 bzw. 32 in ihren gesperrten Zustand geführt werden. Zusätzlich wird an die Eingänge A₁ und A₂ statt der Abstimmspannungen ein Schaltpotential eingekoppelt, das vorzugsweise nahe Bezugspotential oder unterhalb Bezugspotential liegt. Damit werden die Kapazitätsdioden 39 bzw. 42 vollständig in ihren leitenden Zustand versetzt, so daß in den Schwingkreisen des einzelnen Bandfilters 1 vorhandene Signale gegen Bezugspotential bzw. gegen dieses Schaltpotential abgeführt werden. Damit wird zusätzlich eine gute Durchgangsdämpfung des einzelnen Bandfilters 1 erzielt.

In dem in der Figur dargestellten Beispielsfall sind die beiden weiteren einzelnen Bandfilter 2 und 3 für andere Frequenzbereiche vorgesehen.

Das einzelne Bandfilter 2 weist eingangsseitig eine Schaltdiode 61 und ausgangsseitig eine Schaltdiode 62 auf. Diese sind mittels Schaltsignalen SB über Widerstände 63 bzw. 64 aktivierbar.

Die abstimmbaren Schwingkreise des einzelnen Bandfilters 2 sind in entsprechender Weise wie diejenigen des einzelnen Bandfilters 1 aufgebaut. So weist das einzelne Bandfilter 2 eingangs- und ausgangsseitig Koppelinduktivitäten 65 und 66 sowie Koppelkapazitäten 67 und 68 auf. Die Schwingkreise sind ebenfalls in entsprechender Weise wie im einzelnen Bandfilter 1 aufgebaut. Der erste Schwingkreis weist eine Induktivität 69 eine Kapazitätsdiode 70 und eine Kapazität 71 auf. Der zweite Schwingkreis weist eine Induktivität 72, eine Kapazitätsdiode 73 und eine Kapazität 74 auf. Der Verbindungspunkt der Kapazitäten 71 und 74 ist über eine Kapazität 75 mit Bezugspotential gekoppelt. Die Versorgungsspannungen werden über Widerstände 76 bzw. 77 auf den Verbindungspunkt der Schwingkreisinduktivität 69 und einer Kapazität 78 die gegen Bezugspotential geschaltet ist bzw. auf den Verbindungspunkt der Schwingkreisinduktivität 72 und einer Kapazität 79, gekoppelt. Auch das einzelne Bandfilter 2 weist ausgangsseitig ein aus einer Induktivität 80 und einer Kapazität 81 aufgebautes Tiefpaßfilter auf. Abstimmspannungen B₁ und B₂ oder das Schaltpotential werden über Widerstände 82 und 83 eingekoppelt.

Das dritte einzelne Bandfilter 3 weist ebenfalls eingangs- und ausgangsseitig je eine Schaltdiode 91 bzw. 92 auf. Diese sind über Schaltsignale SC, die über Widerstände 93 bzw. 94 eingekoppelt werden können, in den gesperrten Zustand versetzbar.

Das einzelne Bandfilter 3 weist eingangsseitig eine Koppelkapazität 95 und eine Koppelinduktivität 96 auf. Ausgangsseitig sind ebenfalls eine Koppelinduktivität 97 sowie eine Koppelkapazität 98 vorgesehen. Für den ersten Schwingkreis des einzelnen Bandfilters 3 ist eine Kapazitätsdiode 99 vorgesehen, welche anodenseitig mit einer Induktivität 100 sowie der Koppelinduktivität 96 gekoppelt ist. Anodenseitig ist die Kapazitätsdiode 99 über eine Kapazität 101 mit Bezugspotential gekoppelt sowie über einen Widerstand 102 mit einem Eingangssignal C₁, bei dem es sich wiederum entweder um die Abstimmspannung oder um das Schaltpotential handeln kann.

Für den zweiten Schwingkreis ist eine Kapazitätsdiode 103 vorgesehen, welche anodenseitig mit der Koppelinduktivität 97 sowie einer Schwingkreisinduktivität 108 gekoppelt ist.

Auch die Kapazitätsdiode 103 ist über eine Kapazität 108 mit Bezugspotential sowie über einen Widerstand 105 mit dem Abstimmungs- bzw. Schaltpotential gekoppelt.

Der Verbindungspunkt der Induktivitäten 100 und 108 ist über eine Kapazität 106 mit Bezugspotential und über einen Widerstand 107 mit Versorgungspotential (+5 V) gekoppelt.

Auch in dem einzelnen Bandfilter 3 kann den Eingängen C₁, C₂ entweder eine Abstimmspannung zugeführt werden, welche so gewählt ist, daß die Kapazitätsdiode 99 bzw. 103 in Abhängigkeit dieser Spannung ihre Kapazität verändern, wodurch die Abstimmfrequenz der Schwingkreise des einzelnen Bandfilters 3 veränderbar ist. Wird an die Eingänge C₁, C₂ dagegen das Schaltpotential angelegt, werden die Dioden 99 bzw. 103 vollständig in ihren leitenden Zustand überführt, so daß alle Signale auf dieses Schaltpotential abgeführt werden.

Den drei einzelnen Bandfiltern 1, 2 und 3 ist ausgangsseitig ein in der Figur nur schematisch dargestellter Mischer 110 nachgeschaltet, welcher ausgangsseitig ein Niederfrequenzsignal NF liefert.

Von den drei einzelnen Bandfiltern 1, 2 und 3 ist zu einer Zeit jeweils nur eines aktiviert, d.h. die beiden anderen sind in den gesperrten Zustand überführt. Dies bedeutet, daß die beiden jeweils in den gesperrten Zustand überführten einzelnen Bandfilter mittels der Schaltsignale SA, SB oder SC gesperrt werden, in dem die eingangsseitig bzw. ausgangsseitig vorgesehenen Schaltdioden 31, 61, 91 bzw. 32, 62, 92 in den gesperrten Zustand überführt werden. Durch diese Schaltdioden wird bereits eine relativ gute Entkopplung der einzelnen Bandfilter gegeneinander erzielt. Jedoch bleibt die Durchgangsdämpfung ungenügend, so daß auch das gesperrte einzelne Bandfilter ausgangsseitig immer noch Signalreste liefert.

Zur Verbesserung dieser Durchgangsdämpfung sind die Schaltdioden 39, 42, 70, 72 und 99, 103 so verschaltet, daß sie außer als Kapazitätsdioden zur Abstimmung der Schwingkreise auch zur Sperrung der einzelnen Bandfilter bzw. zur Abführung von in den Bandfiltern eingespeisten Signalen dienen. Dazu werden diese Schaltdioden in den leitenden Zustand versetzt, so daß sie diese Signale gegen das Schaltpotential abführen. Damit wird auch eine hohe Durchgangsdämpfung erzielt, so daß nun tatsächlich die deaktivierten einzelnen Bandfilter in der Gesamtschaltung nicht mehr in Erscheinung treten und nur dasjenige einzelne Bandfilter wirksam ist, das eingeschaltet ist und wirksam sein soll.

## Patentansprüche

1. Umschaltbares Bandfilter für einen Mehrband-Tuner mit wenigstens zwei parallel angeordneten einzelnen Bandfiltern (1, 2, 3), wobei in den einzelnen Bandfiltern (1, 2, 3) jeweils wenigstens eine Kapazitätsdiode (39, 42; 70, 73; 99, 103) zur Frequenz-Abstimmung wenigstens eines Schwingkreises der einzelnen Bandfilter (1, 2, 3) vorgesehen ist und wobei die einzelnen Bandfilter (1, 2, 3) jeweils eingangs- und ausgangsseitig je eine Schaltdiode (31, 32; 61, 62; 91, 92) aufweisen, welche mittels Gleichspannungen in den sperrenden oder in den leitenden Zustand schaltbar ist, dadurch gekennzeichnet,
daß die Kapazitätsdioden (39, 42; 70, 73; 99, 103) zusätzlich zur Sperrung der einzelnen Bandfilter (1, 2, 3) einsetzbar sind und so in den Schwingkreis des umschaltbaren Bandfilters integriert sind, daß die Kapazitätsdioden (39, 42; 70, 73; 99, 103) in Abhängigkeit eines Schalt-Potentials den Schwingkreis gegen ein Schalt-Potential koppeln und daß Mittel vorgesehen sind, welche bei Sperrung eines einzelnen Bandfilters (1, 2, 3) der jeweiligen Kapazitätsdiode (39, 42; 70, 73; 99, 103) ein Schaltpotential und welche bei Betrieb im nicht gesperrten Zustand der jeweiligen Kapazitätsdiode eine Abstimmspannung zuführen.

2. Umschaltbares Bandfilter nach Anspruch 1, dadurch gekennzeichnet,
daß zur Sperrung der einzelnen Bandfilter (1, 2, 3) die jeweilige Kapazitätsdiode (39, 42; 70, 73; 99, 103) mittels des Schalt-Potentials in den leitenden Zustand versetzt wird und den jeweiligen Schwingkreis gegen das Schalt-Potential koppelt.

3. Umschaltbares Bandfilter nach einem der Ansprüche 1 oder 2, dadurch gekennzeichnet,
daß die Kapazitätsdioden (39, 42; 70, 73; 99, 103) anodenseitig mit einer positiven Gleichspannung und kathodenseitig mit dem Schalt-Potential und über wenigstens eine Kapazität (42, 75, 106) mit einem Bezugspotential gekoppelt sind.

4. Umschaltbares Bandfilter nach einem der Ansprüche 1 bis 3, dadurch gekennzeichnet,
daß die Kapazitätsdioden (39, 42; 70, 73; 99, 103) anodenseitig mit wenigstens einer Induktivität (38, 43, 61, 72, 100 104) des jeweiligen Schwingkreises gekoppelt sind.

5. Umschaltbares Bandfilter nach einem der Ansprüche 1 bis 4, dadurch gekennzeichnet,
daß bei inaktivem Schalt-Potential eine Abstimmspannung zur Frequenz-Abstimmung der einzelnen Bandfilter (1, 2, 3) auf die Kathode der jeweiligen Kapazitätsdiode (39, 42; 70, 73; 99, 103) gekoppelt wird.

6. Mehrband-Tuner mit einem umschaltbaren Bandfilter nach einem der Ansprüche 1 bis 5, dadurch gekennzeichnet,
daß die Umschaltung zwischen den einzelnen Bandfiltern (1, 2, 3) in der Weise vorgenommen wird, daß jeweils nur ein einzelnes Bandfilter (1, 2, 3) aktiviert ist und die übrigen einzelnen Bandfilter (1, 2, 3) mittels der Schalt-Potentiale in den gesperrten Zustand geschaltet sind.

7. Mehrband-Tuner nach Anspruch 6, dadurch gekennzeichnet,
daß die mittels der Kapazitätsdioden (39, 42; 70, 73; 99, 103) in den gesperrten Zustand geschalteten einzelnen Bandfilter (1, 2, 3) zusätzlich mittels der Schaltdioden (31, 32; 61, 62; 91, 92) gesperrt werden

8. Mehrband-Tuner nach einem der Ansprüche 6 oder 7, dadurch gekennzeichnet,
daß der Tuner einen Breitbandverstärker (17) aufweist, dem ein umschaltbares Bandfilter (1, 2, 3) nachgeschaltet ist.

## Claims

1. A switchable bandpass filter for a multiband tuner, with at least two parallel-arranged individual bandpass filters (1, 2, 3), which individual bandpass filters (1, 2, 3) comprise at least a capacitance diode (39, 42; 70, 73; 99, 103) for frequency-tuning of at least a resonant circuit of the individual bandpass filters (1, 2, 3), and a switching diode (31, 32; 61, 62; 91, 92) arranged at the inputs and the outputs of the individual bandpass filters (1, 2, 3), said switching diode being switchable to either the blocked state or to the conducting state by means of DC voltages, characterized in that the capacitance diodes (39, 42; 70, 73; 99, 103) are additionally usable for blocking the individual bandpass filters (1, 2, 3) and are integrated in the resonant circuit of the switchable bandpass filter (1, 2, 3) in such a way that, in dependence upon a switching potential, the capacitance diodes (39, 42; 70, 73; 99, 103) couple the resonant circuit to a switching potential, and that means are provided, which apply a switching potential to the relevant capacitance diode (39, 42; 70, 73; 99, 103) when an individual bandpass filter (1, 2, 3) is blocked, and which apply a tuning voltage to the relevant capacitance diode in the unblocked state.

2. A switchable bandpass filter as claimed in claim 1, characterized in that, for blocking the individual bandpass filter (1, 2, 3), the relevant capacitance diode (39, 42; 70, 73; 99, 103) is switched to the conducting state by means of the switching potential and couples the relevant resonant circuit to the switching potential.

3. A switchable bandpass filter as claimed in claim 1 or 2, characterized in that the capacitance diodes (39, 42; 70, 73; 99, 103) are coupled to a positive DC voltage at the anode end and to the switching potential at the cathode end and, via at least a capacitor (42, 75, 106), to a reference potential.

4. A switchable bandpass filter as claimed in any one of claims 1 to 3, characterized in that the capacitance diodes (39, 42; 70, 73; 99, 103) are coupled at the anode end to at least an inductance (38, 43, 61, 72, 100, 104) of the relevant resonant circuit.

5. A switchable bandpass filter as claimed in any one of claims 1 to 4, characterized in that, in the case of an inactive switching potential, a tuning voltage for frequency-tuning of the individual bandpass filters (1, 2, 3) is applied to the cathode of the relevant capacitance diode (39, 42; 70, 73; 99, 103).

6. A multiband tuner comprising a switchable bandpass filter as claimed in any one of claims 1 to 5, characterized in that the switching between the individual bandpass filters (1, 2, 3) is performed in such a way that only one individual bandpass filter (1, 2, 3) is activated at any time and that the other individual bandpass filters (1, 2, 3) are switched to the blocked state by means of the switching potentials.

7. A multiband tuner as claimed in claim 6, characterized in that the individual bandpass filters (1, 2, 3) which are switched to the blocked state by means of the capacitance diodes (39, 42; 70, 73; 99, 103) are additionally blocked by means of the switching diodes (31, 32; 61, 62; 91, 92).

8. A multiband tuner as claimed in any one of claim 6 or 7, characterized in that the tuner includes a broadband amplifier (17) preceding a switchable bandpass filter (1, 2, 3).

## Revendications

1. Filtre passe-bande commutable pour un tuner multi-gammes avec au moins deux filtres passe-bande (1, 2, 3) individuels disposés parallèlement, au moins une diode à capacité variable (39, 42; 70, 73; 99, 103) étant prévue dans les filtres passe-bande individuels (1, 2, 3) en vue de la syntonisation des fréquences d'au moins un circuit oscillant des filtres passe-bande individuels (1, 2, 3) et les filtres passe-bande (1, 2, 3) individuels présentant respectivement côté entrée et côté sortie une diode de commutation (31, 32; 61, 62; 91, 92) qui peut être commutée à l'aide de tensions continues à l'état bloqué ou à l'état conducteur, caractérisé en ce que les diodes à capacité variable (39, 42; 70, 73; 99, 103) peuvent être utilisées en plus pour le blocage des filtres passe-bande (1, 2, 3) individuels et sont ainsi intégrées dans le circuit oscillant du filtre passe-bande commutable de telle sorte que les diodes à capacité variable (39, 42, 70, 73, 99, 103) couplent le circuit oscillant à un potentiel de commutation en fonction d'un potentiel de commutation et qu'il est prévu des moyens qui, en cas de blocage d'un filtre passe-bande individuel (1, 2, 3) de la diode à capacité variable respective (39, 42, 70, 73, 99, 103) amènent un potentiel de commutation et qui amènent une tension de syntonisation en cas de fonctionnement à l'état non bloqué de la diode à capacité variable respective.

2. Filtre passe-bande commutable selon la revendication 1, caractérisé en ce qu'en vue du blocage des filtres passe-bande individuels (1, 2, 3), la diode à capacité variable (39, 42; 70, 73; 99, 103) respective est amenée à l'état conducteur à l'aide du potentiel de commutation et couple le circuit oscillant respectif au potentiel de commutation.

3. Filtre passe-bande commutable selon l'une des revendications 1 ou 2, caractérisé en ce que les diodes à capacité variable (39, 42; 70, 73; 99, 103) sont couplées côté anode à une tension continue positive et côté cathode au potentiel de commutation et, par l'intermédiaire d'au moins une capacité (42, 75, 106), à un potentiel de référence.

4. Filtre passe-bande commutable selon l'une des revendications 1 à 3, caractérisé en ce que les diodes à capacité variable (39, 42; 70, 73; 99, 103) sont couplées côté anode à au moins une inductance (38, 43, 61, 72, 100, 104) du circuit oscillant respectif.

5. Filtre passe-bande commutable selon l'une des revendications 1 à 4, caractérisé en ce qu'en cas de potentiel de commutation inactif, une tension de syntonisation est couplée en vue de la syntonisation des fréquences des filtres passe-bande individuels (1, 2, 3) sur la cathode de la diode à capacité variable respective (39, 42; 70, 73; 99, 103).

6. Tuner multi-gammes avec un filtre passe-bande commutable selon l'une des revendications 1 à 5, caractérisé en ce que la commutation entre les filtres passe-bande individuels (1, 2, 3) est effectuée de telle manière que seul un filtre passe-bande individuel (1, 2, 3) est respectivement activé et les autres filtres passe-bande individuels (1, 2, 3) sont montés à l'état bloqué à l'aide des potentiels de commutation.

7. Tuner multi-gammes selon la revendication 6, caractérisé en ce que les filtres passe-bande (1, 2, 3) individuels montés à l'état bloqué à l'aide des diodes à capacité variable (39, 42; 70, 73; 99, 103) sont bloqués en plus à l'aide des diodes de commutation (31, 32, 61, 62, 91, 92).

8. Tuner multi-gammes selon l'une des revendications 6 ou 7, caractérisé en ce que le tuner présente un amplificateur à large bande (17) en aval duquel est monté un filtre passe-bande commutable (1, 2, 3).
